# EUROPEAN PATENT APPLICATION

(11) **EP 1 003 043 A1**
(43) Date of publication of application: **24.05.2000**
(21) Application number: 99122882.6
(22) Date of filing: 17.11.1999
(51) Int. Cl.: G01R 11/24, G06M 3/06

(54) **Consumption meter**

(30) Priority: 17.11.1998 GB 9825120
(71) Applicant: Siemens Metering Limited, Oldbury, Bracknell, Berkshire, RG12 8FZ (GB)
(72) Inventor: Warwick, Ronald, Alierton, Liverpool L18 2DN (GB); Taylor, Robert Edward Jonathan, Bramwell, Cheshire SL7 3LJ (GB)
(74) Representative: Kay, Ross Marcel

(57) **Abstract**

In addition to displaying a meter reading for a commodity, such as gas or electricity, solid state commodity meters may indicate the presence of errors in their circuitry. The error indication system includes a meter apparatus (100) with a display (108), which presents an error message (106) in a check digit field (104). This check digit field (104) allows the commodity supplier to ascertain incorrect, incomplete or fraudulent meter readings while the customer remains unaware of the meaning of the error message (106).

## Description

The present invention relates to a meter for measuring consumption of a commodity and for indicating when incorrect, incomplete or fraudulent meter readings have been detected.

It is known to provide a meter used for measuring consumption of a commodity, for example gas, water or electricity, which displays a simple single digit error flag, for example, a letter of the alphabet. The error flag is displayed when electronic circuitry in the meter detects an error relating to the good operation of the meter.

However, at present, there is no combined facility for detecting and indicating whether incorrect, incomplete or fraudulent meter readings have been taken.

It is therefore an object of the present invention to provide such a facility and so obviate or at least mitigate the above-mentioned disadvantage.

According to the present invention, there is provided a meter apparatus for measuring consumption of a commodity, the meter apparatus comprising a measuring module arranged to generate a measurement field representing a commodity consumption measurement, diagnostic means for generating at least one additional digit field corresponding to the integrity of the measurement field, wherein data contained in the at least one additional digit field generated by the diagnostic means is replaced by status data in response to a predetermined meter condition.

Preferably, the data contained in the measurement field is encoded.

Preferably, the at least one additional digit field corresponds to at least one check digit when the predetermined meter condition has not occurred.

Preferably, the at least one check digit is encoded according to an encoding scheme. More preferably, the encoding scheme used to encode the at least one check digit is changeable.

Preferably, the meter apparatus is capable of receiving data from an input device, for example, a meter reading device. More preferably, the input device is capable of transmitting an updated encoding scheme to the diagnostic means, the diagnostic means being arranged to replace the encoding scheme with the updated encoding scheme.

The at least one additional digit field is not recognised as such by the customer or meter reader. However, the at least one additional digit field is preferably recognised by a meter reading device used by a supplier of a commodity. It is thus possible to provide an apparatus for metering consumption of a commodity, which can indicate to the commodity supplier that an inaccurate, incomplete or fraudulent meter reading has been supplied while remaining transparent to the customer or meter reader. As mentioned above, known meters can only flag problems with the good operation of the meter. In response to an inaccurate, incomplete or fraudulent meter reading, the commodity supplier can visit to investigate the cause of the inaccurate, incomplete or fraudulent meter reading further.

At least one embodiment of the invention will now be described, by way of example only, with reference to the accompanying drawing, where:

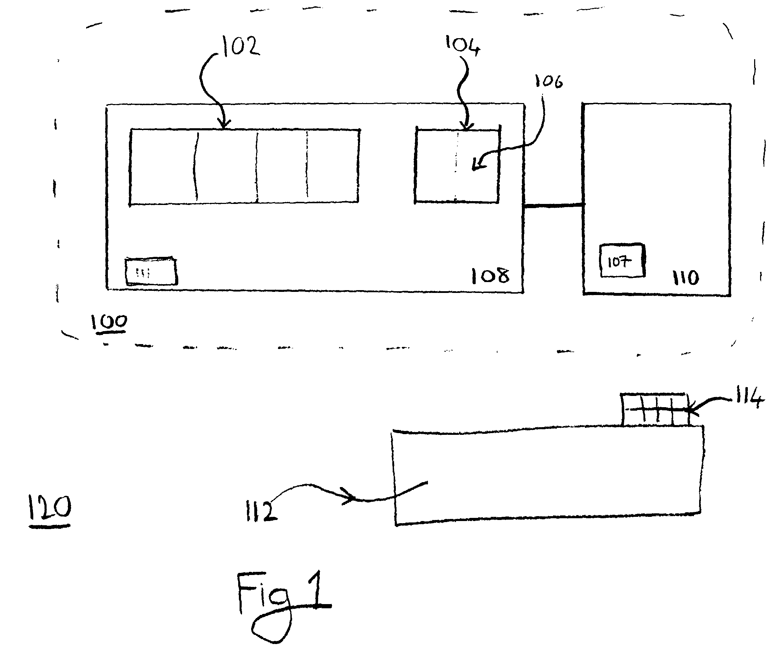

Figure 1 is a schematic diagram of a commodity meter constituting an embodiment of the present invention.

Referring to Figure 1, a gas meter 100 comprises a measuring module 110 and a display 108. The display 108 is a liquid crystal display having a measurement field 102 and a check digit field 104, each field having one or more digits. Of course, other types of output devices as well as other types of display technology can be employed, such as a Light Emitting Diode (LED) display. The meter 100 also has an opto-port 111 for transmission of data contained in the measurement field and the check digit field to meter reading equipment 112. The opto-port 111 can be any optical communications link for communications between the meter 100 and another unit, for example, meter reading equipment 112. Other communications links can be used, for example, radio frequency (RF) links.

The check digit field 104 comprises encoded data 106. Additionally, the measurement field 102 can contain encoded data. The information displayed in the check digit field 104 is capable of being read by the meter reading equipment 112 as part of a commodity consumption reading. The encoded data 106 can then be recognised by the meter reading equipment 112 as both a check digit and a meter status indicator depending upon the operation of the meter, but remains obscure to the customer or other individuals who read the meter 100.

Whether the commodity consumption reading is taken by a customer or by another person reading the meter 100, two checks can thus be made when recording the consumption of a commodity for charging purposes. Firstly, correct reading of the meter can be verified, but if, in response to fraud protection systems (not shown), a particular fraudulent error is detected, the error is reported by the customer or the meter reader for subsequent checking by the commodity supplier. It should be appreciated that other systems can be employed which relate to the good operation of the meter 100, for example fault detection systems.

In operation, the measuring module 110 measures consumption of the commodity, for example gas, and generates data contained in the measuring field 102 corresponding to the amount of the commodity consumed. The data generated by the measuring module 110 is used by a diagnostic unit 107 to generate a check digit contained in the check digit field 104. During normal operation of the meter 100, the data contained in the check digit field 104 is a check digit. However, in the event of a predetermined meter condition occurring, for example, the detection of fraud or a meter fault, the check digit is replaced by a status indicator. Both the data contained in the measurement field 102 and the check digit field 104 are displayed by the display 108.

Furthermore, when the meter 100 is read by the meter reading equipment 112 having an opto-port 114, the codes can be updated by the meter reading equipment 112 so that the codes remain undefinable by the customer or meter reader. Consequently, the updated codes can be transmitted to the meter 100 for recordal before, during or after meter readings are taken.

The invention is not intended to be limited to the applications described in the above described embodiment. In particular the meter 100 is not necessarily a gas meter and can be a meter for measuring consumption of other commodities, for example, fuel, gas, electricity or water.

## Claims

1. A meter apparatus for measuring consumption of a commodity, the meter apparatus comprising a measuring module arranged to generate a measurement field representing a commodity consumption measurement, diagnostic means for generating at least one additional digit field corresponding to the integrity of the measurement field, wherein data contained in the at least one additional digit field generated by the diagnostic means is replaced by status data in response to a predetermined meter condition.

2. A meter apparatus according to Claim 1, wherein data contained in the measurement field is encoded.

3. A meter apparatus according to Claim 1 or Claim 2, wherein the at least one additional digit field corresponds to at least one check digit when the predetermined meter condition has not occurred.

4. A meter apparatus according to Claim 3, wherein the at least one check digit is encoded according to an encoding scheme.

5. A meter apparatus according to Claim 3 or Claim 4, wherein the encoding scheme used to encode the at least one check digit is changeable.

6. A meter apparatus according to any one of the preceding Claims, wherein the meter apparatus is capable of receiving data from an input device.

7. A meter apparatus according to Claim 6, the input device is capable of transmitting an updated encoding scheme to the diagnostic means, the diagnostic means being arranged to replace the encoding scheme with the updated encoding scheme.

8. A meter apparatus substantially as hereinbefore described with reference to Figure 1.
